Europäisches Patentamt

European Patent Office

Office européen des brevets

(11) Publication number: **0 599 418 A2**

## EUROPEAN PATENT APPLICATION

(21) Application number: 93203250.1

(22) Date of filing: 19.11.93

(51) Int. Cl.5: **H03M 7/30**, H03M 7/40

(30) Priority: 27.11.92 GB 9224893

(43) Date of publication of application:
01.06.94 Bulletin 94/22

(84) Designated Contracting States:
CH DE FR GB IT LI

(71) Applicant: PHILIPS ELECTRONICS N.V.
Groenewoudseweg 1
NL-5621 BA Eindhoven(NL)

(72) Inventor: Stribaek, Morten, c/o Int.
Octrooibureau B.V.
Prof. Holstlaan 6
NL-5656 AA Eindhoven(NL)

(74) Representative: De Jongh, Cornelis
Dominicus et al
INTERNATIONAAL OCTROOIBUREAU B.V.,
Prof. Holstlaan 6
NL-5656 AA Eindhoven (NL)

(54) Encoding and decoding data.

(57) A method of packing and unpacking encoded symbols, which method has particular but not exclusive application in selecting any one of a number of stored screen texts in different languages for use by a cordless telephone in a particular country. In the method, symbols are encoded on the basis of the higher the probability of a symbol occurring in a text, the fewer the number of bits which are used to represent the signal, and vice versa. The encoded bits are concatenated into bytes of n binary bits, which bytes are stored. The encoded bits relating to a selected one of the screen texts are unpacked by storing n successive bits in a shift register (12). A predetermined bit or number of bits in the shift register (12) is or are unmasked. The unmasked bit or bits is or are compared with at least one codeword of a length corresponding to the number of unmasked bits. When a match is achieved, the bits are decoded and the shift register is topped-up by the addition of further ones of the encoded bits.

FIG. 2

The present invention relates to encoding and decoding data and particularly, but not exclusively, encoding and decoding text-screen languages for use in cordless/cellular telephone handsets.

Cellular telephone systems have been introduced into many countries, each one having its own language. Accordingly it is necessary to have handsets which are able to display text in the language of the country concerned. One option is to have handsets which are dedicated for each language, however this is uneconomic. Another option is to have a universal handset which stores text in several languages and the user is able to select any one of the languages by operating a key. If the text screen languages are stored using 8 bit ASCII-codes, it is estimated that for 9 languages 120 kbytes of storage would be required. As space and current consumption are at a premium in handsets, it is desired to minimise on the maximum size of memory used.

An object of the present invention is to reduce the amount of storage required for storing data.

According to one aspect of the present invention there is provided a method of packing and unpacking encoded symbols, comprising encoding symbols on the basis of the higher the probability of a symbol occurring in a text, the fewer the number of bits which are used to represent the symbol and vice versa, concatenating the encoded bits into bytes of n binary bits and storing said bytes, and unpacking the encoded bits by storing n successive bits, unmasking a predetermined bit or number of bits, comparing the unmasked bit or bits with at least one codeword of a length corresponding to the number of bits unmasked, removing said bits when a match with the codeword is achieved and unpacking a further bit or bits to make-up the number stored to n.

According to another aspect of the present invention there is provided a device for decoding data which is representative of symbols which have been encoded on the basis of the higher the probability of a symbol occurring in a text, the fewer the number of bits which are used to represent the symbol and vice versa, the encoded bits being concatenated into bytes of n bits, the device comprising means for storing the encoded text, means for storing codewords representative of all the possible symbols used in the text, means for storing n bits of the encoded text, means for selecting at least one of said n bits, means for comparing the selected at least one bit with a stored one of said codewords having the same number of bits and means for determining if there is a match between them.

The present invention is based on the realisation that the probability distribution of symbols is uneven and as an example the probability of occurrence of the space character is higher than 20 per cent. Accordingly the number of bits needed to represent a symbol can be related to its probability of occurrence with fewer bits being used to represent a symbol having a higher probability of occurrence and a greater number of bits being used to represent a symbol having a lower probability of occurrence. Since the codewords representing the various symbols will be of different lengths and data is stored in the form of bytes then in order to avoid padding short codewords with zeros to make their lengths up to a byte, the bits representing successive symbols are concatenated and the string of bits is divided into bytes for storage. By encoding and packing data in this way a significant economy can be achieved in the space required to store a predetermined data compared to using ASCII 8-bit characters. On read-out the bytes read out have to be unpacked into codewords which are decoded into symbols. In the case of storing menu texts in a plurality of languages then at any one time, text in one language can be unpacked from a main memory, decoded and stored as symbols, for example ASCII 8 bit symbols, in a separate random access memory.

The present invention further relates to a telephone handset comprising means for storing encoded symbols representative of screen texts in at least two languages, said data having been encoded on the basis of the higher the probability of a symbol occurring in the screen text, the fewer the number of bits which are used to represent the symbol and vice versa, the encoded bits being concatenated into bytes of n bits, means for decoding one of the screen texts and means for storing the screen text, wherein the means for decoding one of the at least two screen texts comprises means for storing codewords representative of all the possible symbols used in the text, shift register means for storing n bits of the encoded text, means for selecting at least one of said n bits, means for comparing the selected at least one bit with a stored one of said codewords having the same number of bits and means for determining if there is a match between them.

The present invention will now be described, by way of example, with reference to the accompanying drawings, wherein:

Figure 1 is a diagram of a Huffman code-tree,

Figure 2 is a block schematic diagram of an embodiment of decoder for unpacking encoded data,

Figure 3 is a flow chart relating to unpacking encoded data, and

Figure 4 is a block schematic diagram of a cellular telephone handset.

For convenience of description, the present invention will be described with reference to encoding/decoding menu-texts for a cellular telephone handset having the capability of displaying text in a preselected one of a plurality of languages. However the present invention may be used in any other suitable application in which it is desired to economise on the storage of predetermined data.

If it is assumed that only upper case characters are used in the menu-texts then only about 50 different symbols will be required requiring an average of 5.65 bits ($\log_2 50$) to represent each symbol. By adopting a method of encoding in which symbols having a high probability of occurrence are represented by fewer bits than are used to represent symbols having a lower probability of occurrence the overall number of bits can be reduced. As an example a space character may be encoded as OOb (two binary bits, where b represents binary) and all other symbols are encoded using a greater number of bits.

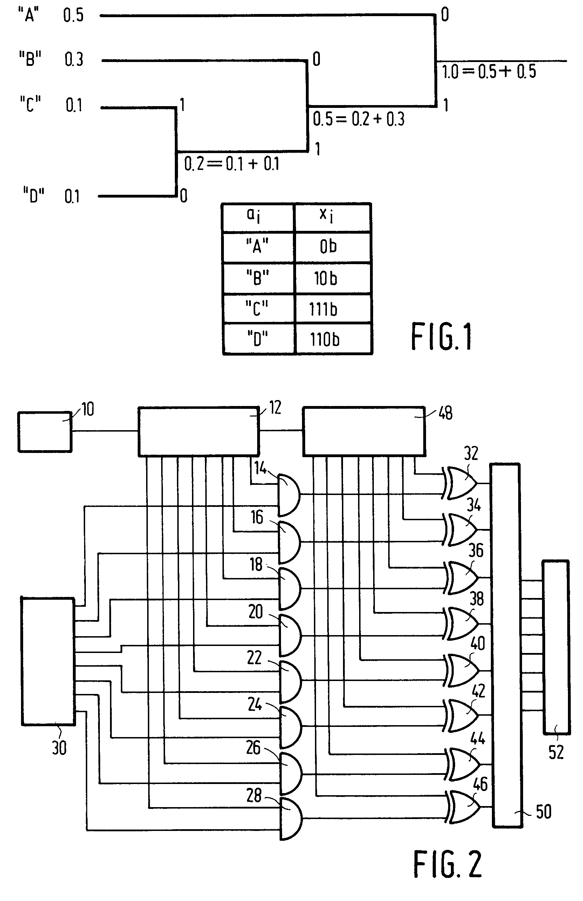

Huffman, see John G. Proakis: "Digital Communications" Second Edition, published by McGraw Hill, 1989, devised an algorithm to construct codewords for the symbols, given their probabilities of occurrence. Figure 1 illustrates a simplified Huffman code-tree. The Huffman code is optimal with respect to the size of the encoded menu-texts, if the symbols in the text are uncorrelated. In Figure 1, the symbol is represented as $a_i$, where i = 1.L and L comprises the number of different symbols in the menu-texts, and the codeword as $X_i$. It is assumed that "A" has a estimated probability P('A') of 0.5 and that P('B') = 0.3, P('C') = 0.1 and P('D') = 0.1. In the codeword-tree, the branches with the smallest (summed) probabilities are combined from left to right. Each branch is assigned (arbitrarily) either a "1" or a "0". After all branches are combined, the codeword-tree is traversed from right to left, whereby the codewords are obtained. It can be deduced that symbol A is represented by codeword 0b, "B" by 10b, "C" by 111b and "D" by 1 10b. By way of example the following symbols are encoded using the illustrated codeword-tree, the bits are concatenated and divided into bytes of 8 bits,

$$A \quad A \quad A \quad B \quad B \quad B \quad A \quad A \quad C \quad D$$

$$0 \quad 0 \quad 0 \quad 10 \quad 10 \quad 10 \quad 0 \quad 0 \quad 111 \quad 110$$

$$= 00010101.00011111.0$$

This example illustrates how 10 symbols of source data can be packed to 17 bits which require 2 bytes plus 1 bit of storage instead of 17x8 bits or 17 bytes of storage if ASCII 8 bit coding is used.

In order to be able to unpack and decode the encoded sequence, it is necessary for the decoder in a handset to be preprogrammed with all the possible codewords and their corresponding symbols. The codewords are stored in the decoder as bytes with the more significant bit or bits being the codeword $X_i$ with the remainder of the byte comprising zeros, thus "A" is stored as 00000000b, "B" as 10000000b, "C" as 11100000b and "D" as 11000000b. Also the codewords are categorised by their lengths, for example codewords of length 3 bits are those representing "C" and "D" because each has 3 actual bits plus 5 zeros to make up a 8 bit byte.

Figure 2 is a block schematic diagram of a decoder. A PROM 10 reads out the text in the selected language into an 8 stage window register 12. Each of the register stages is connected to one input of a respective AND gate 14 to 28. A mask generator 30 reads out a preselected mask the bits of which are applied in parallel to a second input of the AND gates 14 to 28. Outputs of the AND gates are applied to respective first inputs of EX--OR gates 32 to 46, second inputs of which receive bits of a codeword read-out from a codeword PROM. The outputs of the EX-OR gates 32 to 46 are applied to an ASCII decoder 50 which has parallel outputs connected to a RAM 52.

In operation the decoder first has to unpack a codeword from the bytes and then decode it. The unpacking operation involves writing the stored concatenated codewords from the PROM 10 into the masked window register 12 which has a capacity equivalent to one byte. An initial operation is to unmask the bit or number of bits corresponding to the shortest codeword which in the illustrated example is 1 bit. This is done applying the first byte 00010101 to a first input of the "AND" gates 14 to 28 and a mask 1000000 to a second input, the parallel outputs of the AND gates 14 to 28 will be a byte 00000000. This output byte is then applied in parallel to one input of the Exclusive-OR (EX-OR) gates 32 to 46 to a second input of which is applied as stored codeword, say 0000000, from the ROM 48. In this example the parallel output of the EX-OR gates 32 to 46 will be 00000000 and as the EX-OR output is zero this indicates that a match between the unpacked bit and the codeword has been achieved. As the codeword 00000000 represents "A" then A is stored as an ASCII-8 bit symbol in the RAM 52. The contents of the register 12 are updated by discarding the O at the most significant bit position and adding the first bit from the next following byte which in our example will be 0. Thus the content of the masked window shift register 12 will be 00101010. The next two zeros will be decoded as letter "A"s. The content of the register 12 will now be 10101000. The first cycle of the unpacking operation will be to have a single bit unmasking which will give 10000000. When this is EX-ORed with the only single bit codeword 00000000, a non-zero result is obtained. By pre-arrangement there will not be a single bit codeword 10000000. The next operation is to unmask the two most significant bits using a mask 11000000, which will give a result from the AND gate of 10000000. This is EX-ORed with a prestored 2 bit codeword which in this example will be 10000000 to give a zero result. If a match was not obtained, other two bit codewords, if stored, would be tried and if a match is still not found then the next mask is used. For the sake of completeness the 8-following masks can be used

1 0 0 0 0 0 0 0 (mask most significant bit)
1 1 0 0 0 0 0 0 (mask 2 most significant bits)
1 1 1 0 0 0 0 0 (mask 3 msbs)
1 1 1 1 0 0 0 0 (mask 4 msbs)
1 1 1 1 1 0 0 0 (mask 5 msbs)
1 1 1 1 1 1 0 0 (mask 6 msbs)
1 1 1 1 1 1 1 0 (mask 7 msbs)
1 1 1 1 1 1 1 1 (Mask 8 msbs)

The last mask is 8 binary ones, therefore masking the 8-bit window register will give the window register itself.

If there are codewords longer than 8-bits, these would in theory require a 16-bit window register and 16-bit masks. For example to test for a 1O-bit codeword a 2 byte mask would be required, that is 1 1 1 1 1 1 1 1 . 1 1 0 0 0 0 0 0 . When the decoder tries to obtain a matching codeword, it starts by testing for codewords of length 1, 2, 3 ..., 8 requiring only an 8-bit window register. If the decoder has not found a match among codewords of length less than or equal to 8 bits, then it stores the 8 most significant bits of the window register in a temporary 8 bit register, and then "slides" the window-register 8 bits right. As the decoder now knows that the codeword must be more than 8 bits long, it does not need the 8 most significant bits of a hypothetical 16 bit mask as they would all be ones. Therefore only the 8 least significant bits is stored for masks corresponding to codewords longer than 8 bits and a one byte mask is used to test for a 10 bit codeword, that is 11000000b.

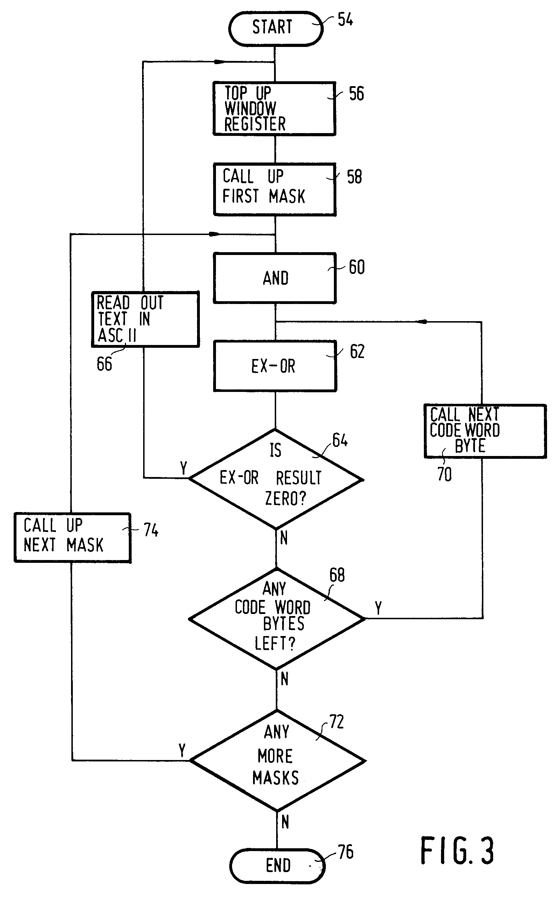

As an alternative to the Figure 2 embodiment of a decoder, the unpacking can be done by a microcontroller in the handset. Figure 3 illustrates a flow chart for this operation. The flow chart begins with a start block 54. Block 56 indicates the operation of topping up the window register. Block 58 indicates the operation of calling up the first mask which operation is followed in block 60 by comparing the bits in the register with the mask in an AND operation. Block 62 indicates the operation comparing the unmasked bits with a codeword having a corresponding number of bits. Block 64 indicates checking if the result of the EX-OR operation is zero (indicating a match). If the answer is Yes(Y) then the flow chart moves onto block 66 which indicates the reading out of the text in ASCII after which the chart returns to the block 56.

If the answer to the block 64 is No(N) then a check is made to see if there are any more codewords of that length left. If the answer is Yes-(Y) then the next codeword is read-out, block 70, and the flow chart reverts to the block 62. If the answer is No(N), then a check is made to see if there are any more masks. If the answer is Yes(Y), then the next mask is called-up, block 74, and the flow chart reverts to the block 60. If the answer is No(N) then the flow chart is terminated, block 76.

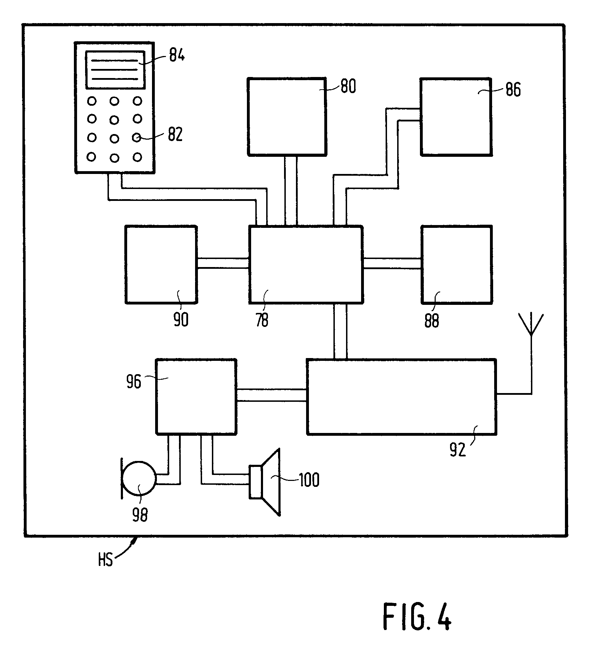

Figure 4 is a block schematic diagram of a cellular handset HS.

The operation of the handset is controlled by a microcontroller 78 to which is connected a program ROM 80, a keypad 82, LCD panel 84, a PROM 86 for storing the menu texts in a plurality of languages, a ROM 88 for storing all the possible codewords, a RAM 90 for storing a decoded menu text in one of the languages, and an RF module 92 connected on the one hand to an antenna 94 and on the other hand to an audio section 96 to which a microphone 98 and a loudspeaker 100 are connected.

The basic operation of the handset is known in the art and does not need to be elaborated on and the unpacking and decoding of a menu-text has already been described with reference to Figure 3.

From reading the present disclosure, other modifications will be apparent to persons skilled in the art. Such modifications may involve other features which are already known in the design, manufacture and use of cellular and cordless handsets and component parts thereof and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

**Claims**

1. A method of packing and unpacking encoded symbols, comprising encoding symbols on the basis of the higher the probability of a symbol occurring in a text, the fewer the number of bits which are used to represent the symbol and vice versa, concatenating the encoded bits into bytes of n binary bits and storing said bytes, and unpacking the encoded bits by storing n successive bits, unmasking a predetermined bit or number of bits, comparing the unmasked bit or bits with at least one codeword of a length corresponding to the number of bits unmasked, removing said bits when a match with the codeword is achieved and unpacking a further bit or bits to make-up the number stored to n.

2. A method as claimed in claim 1, characterised in that the comparing operation commences by the most significant bit(s) of the n bits stored being unmasked and compared with the codeword representing the symbol having the highest probability of occurring.

3. A method as claimed in claim 1 or 2, characterised in that the symbols are encoded using a coding tree which takes into account the probabilities of occurrence of the symbols.

4. A method as claimed in claim 1, 2 or 3, characterised in that the unmasking operation makes use of a sequence of masks, each of the masks comprising a n-bit byte formed by P (where P is an integer between 1 and n) binary 1 bits commencing from the most significant bit position padded by binary 0 bits, in that the comparison is made by applying the binary bits of the mask to one input of AND gate means and the n successive bits to a second input of the AND gate means, in that an n-bit byte at the output of the AND gate means is applied to one input of an Exclusive-OR (EX-OR) gate means and a byte comprising a codeword having n bits is applied to a second input of the EX-OR gate means, and in that if the output of the EX-OR gate means is zero, the codeword is decoded and if it is not zero the cycle is repeated with another codeword having n bits being applied to the second input of the EX-OR gate means until either a zero is obtained or the codewords are exhausted in which case another size of mask is used and the process repeated.

5. A device for decoding data which is representative of symbols which have been encoded on the basis of the higher the probability of a symbol occurring in a text, the fewer the number of bits which are used to represent the symbol and vice versa, the encoded bits being concatenated into bytes of n bits, the device comprising means for storing the encoded text, means for storing codewords representative of all the possible symbols used in the text, means for storing n bits of the encoded text, means for selecting at least one of said n bits, means for comparing the selected at least one bit with a stored one of said codewords having the same number of bits and means for determining if there is a match between them.

6. A device as claimed in claim 5, characterised in that the means for storing the n bits comprises an n-stage shift register means, and in that the means for selecting at least one of said n bits comprises AND gate means having inputs connected to the shift register means and to means for producing a mask comprising binary 1 bit or bits at preselected position(s).

7. A device as claimed in claim 6, characterised in that the means for comparing comprises EX-OR gate means having inputs coupled to an output of the AND gate means and to the means for storing codewords.

8. A telephone handset comprising means for storing encoded symbols representative of screen texts in at least two languages, said data having been encoded on the basis of the higher the probability of a symbol occurring in the screen text, the fewer the number of bits which are used to represent the symbol and vice versa, the encoded bits being concatenated into bytes of n bits, means for decoding one of the screen texts and means for storing the screen text, wherein the means for decoding one of the at least two screen texts comprises means for storing codewords representative of all the possible symbols used in the text, shift register means for storing n bits of the encoded text, means for selecting at least one of said n bits, means for comparing the selected at least one bit with a stored one of said codewords having the same number of bits and means for determining if there is a match between them.

9. A telephone handset as claimed in claim 8, characterised by radio transceiving means for transmitting signals to and receiving signals from a remote base station.

FIG.1

FIG. 2

FIG.3

FIG.4